(19) **Europäisches Patentamt / European Patent Office / Office européen des brevets**

(11) **EP 2 937 965 B1**

(12) **EUROPEAN PATENT SPECIFICATION**

(45) Date of publication and mention of the grant of the patent:
**16.11.2016 Bulletin 2016/46**

(21) Application number: **14165985.4**

(22) Date of filing: **25.04.2014**

(51) Int Cl.:
***H02J 3/38*** (2006.01)

(54) **Detection of islanding state in electricity network**

Erkennung von Inselbildungszustand im Stromnetz

Détection d'état d'îlotage dans un réseau d'électricité

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**28.10.2015 Bulletin 2015/44**

(73) Proprietor: **ABB Schweiz AG
5400 Baden (CH)**

(72) Inventors:
• **Juvonen, Linda
00380 Helsinki (FI)**
• **Routimo, Mikko
00380 Helsinki (FI)**

(74) Representative: **Kolster Oy Ab
Iso Roobertinkatu 23
PO Box 148
00121 Helsinki (FI)**

(56) References cited:
**EP-A2- 0 810 713     WO-A2-2011/097147**

• **SEUL-KI KIM ET AL: "Frequency-Shift Acceleration Control for Anti-Islanding of a Distributed-Generation Inverter", IEEE TRANSACTIONS ON INDUSTRIAL ELECTRONICS, IEEE SERVICE CENTER, PISCATAWAY, NJ, USA, vol. 57, no. 2, 1 February 2010 (2010-02-01), pages 494-504, XP011297383, ISSN: 0278-0046**

## Description

FIELD OF THE INVENTION

The present invention relates to detection of a three-phase islanding state in a three-phase electricity network.

Distributed energy resource units, like solar cells or wind turbines, connected to a common electricity network may provide in this electricity network islands, i.e. parts of the common electricity network, which are provided with power generation of their own. A three-phase islanding state is a loss-of-mains situation in which all three phases of an electricity network incorporating power generation lose connection with the rest of the common electricity network. It is important to detect a three-phase islanding state since it causes a safety hazard within the electricity network separated from the common electricity network.

In a known method a power supply assembly supplying power into a three-phase electricity network is controlled by a frequency reference signal adapted to deviate the output frequency of the power supply assembly from a grid frequency, wherein a three-phase islanding state is detected if an output frequency of the power supply assembly exits an allowable value range. Said grid frequency represent a frequency of a common electricity network whose part the three-phase electricity network is in normal operating conditions. The frequency reference signal is formed by multiplying a difference between the output frequency of the power supply assembly and the grid frequency with a disturbance constant.

Above known method for three-phase islanding detection increases harmonic distortion in the electricity network and/or detect a three-phase islanding state slowly depending on a magnitude of the disturbance constant.

SEUL-KI KIM ET AL: "Frequency-Shift Acceleration Control for Anti-Islanding of a Distributed-Generation Inverter", EP 0 810 713 A2 and WO 2011/097147 A2 all disclose the preamble of the independent claims 1 and 10.

BRIEF DESCRIPTION OF THE INVENTION

An object of the present invention is to provide a method and a system for implementing the method so as to alleviate the above disadvantages. The objects of the invention are achieved by a method and a system which are characterized by what is stated in the independent claims. The preferred embodiments of the invention are disclosed in the dependent claims.

The invention is based on the idea of disturbing a frequency reference signal of a power supply assembly during a normal operating state of an electricity network with a stimulus signal which is a function of an active output current of the power supply assembly.

An advantage of the method and system of the invention is that a three-phase islanding state can be detected quickly and without unduly increasing harmonic distortion in the electricity network.

BRIEF DESCRIPTION OF THE DRAWINGS

In the following the invention will be described in greater detail by means of preferred embodiments with reference to the attached drawings, in which

Figure 1 shows a block diagram illustrating a method for detecting a three-phase islanding state according to an embodiment of present invention; and
Figure 2 shows more detailed information on the block diagram of Figure 1.

DETAILED DESCRIPTION OF THE INVENTION

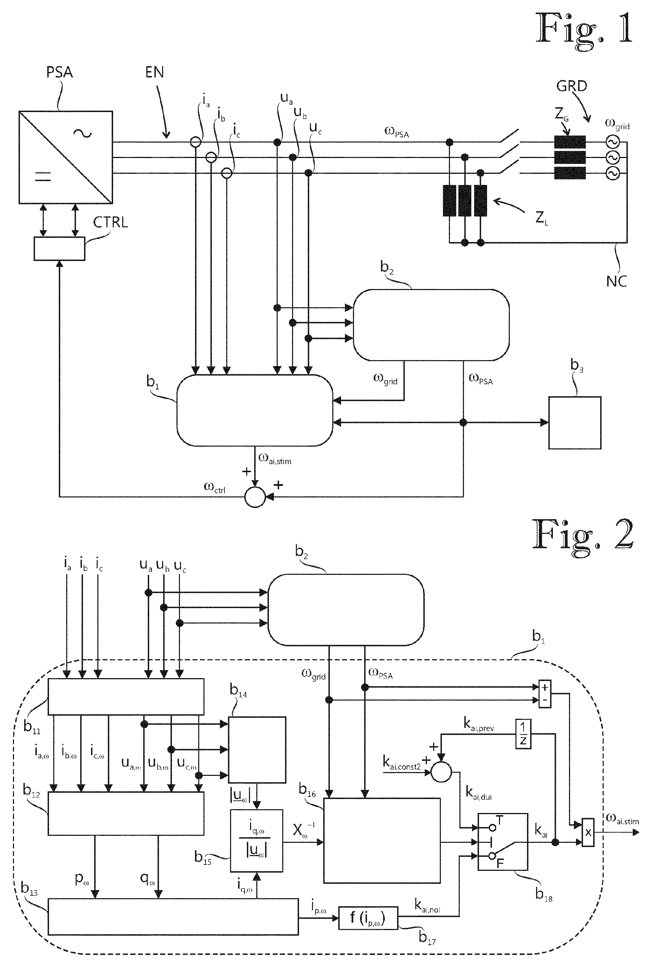

Figure 1 shows a block diagram illustrating a method for detecting a three-phase islanding state in a three-phase electricity network. Figure 1 also shows a three-phase electricity network EN and a common electricity network GRD whose part the three-phase electricity network EN is in normal operating conditions, i.e. when an islanding state is not present in the electricity network EN. The electricity network EN is in a three-phase islanding state which is illustrated by an open three-phase switch between the electricity network EN and the common electricity network GRD. Herein a common electricity network is an electricity network larger than the three-phase electricity network whose islanding state the method is detecting.

The electricity network EN comprises load $Z_L$ connected to the phases of the electricity network EN. Line impedance of the common electricity network GRD is denoted with $Z_G$. In the three-phase islanding state of Figure 1 the electricity network EN has lost connection with the common electricity network GRD and therefore impedance seen from an output of the power supply assembly PSA has changed.

The electricity network EN of Figure 1 is provided with a neutral conductor NC. However, present invention can also be utilized in electricity networks which do not have a neutral conductor.

The method for detecting a three-phase islanding state in the electricity network EN comprises supplying power into the electricity network EN by a power supply assembly PSA having an output frequency $\omega_{PSA}$, controlling the output frequency $\omega_{PSA}$ of the power supply assembly PSA with a frequency reference signal $\omega_{ctrl}$ adapted to deviate the output frequency $\omega_{PSA}$ of the power supply assembly PSA from a grid frequency $\omega_{grid}$ representing a frequency of the common electricity network GRD whose part the three-phase electricity network EN is in normal operating conditions, monitoring a magnitude of a frequency quantity obtainable from the output frequency $\omega_{PSA}$ of the power supply assembly, and detecting a three-phase islanding state in block $b_3$ if the magnitude of the frequency quantity exits an allowable value range. Typically the allowable value range is set by a grid code. For example, in an electricity network whose nominal frequency is 50 Hz, an allowable value range may be from 47 Hz to 52 Hz.

When an islanding state is not present the output frequency $\omega_{PSA}$ of the power supply assembly PSA follows actual frequency of the common electricity network GRD regardless of the frequency reference signal $\omega_{ctrl}$. This result from the fact that the common electricity network GRD is a very rigid network compared to the electricity network EN. The frequency reference signal $\omega_{ctrl}$ is only capable of deviating the output frequency $\omega_{PSA}$ of the power supply assembly PSA from the grid frequency $\omega_{grid}$ during a three-phase islanding state.

In an embodiment the frequency quantity is an angular frequency of the output of the power supply assembly. In alternative embodiment the frequency quantity is a frequency of the output of the power supply assembly. One skilled in the art understands that although reference signs used for frequency terms in Figures 1 and 2 refer to angular frequency values it is naturally possible to carry out the calculations with temporal frequency values.

Forming of the frequency reference signal $\omega_{ctrl}$ comprises addition of the output frequency $\omega_{PSA}$ of the power supply assembly and a stimulus signal $\omega_{ai,stim}$, according to below equation.

$$\omega_{ctrl} = \omega_{PSA} + \omega_{ai,stim}$$

The stimulus signal $\omega_{ai,stim}$ is formed in block $b_1$ whose input information comprises phase currents $i_a$, $i_b$ and $i_c$ of the electricity network EN, phase voltages $u_a$, $u_b$ and $u_c$ of the electricity network EN, the output frequency $\omega_{PSA}$ of the power supply assembly, and the grid frequency $\omega_{grid}$. The phase currents $i_a$, $i_b$ and $i_c$ as well as the phase voltages $u_a$, $u_b$ and $u_c$ may comprise measured values or estimates provided by control means of the power supply assembly PSA.

Block $b_2$ determines the output frequency $\omega_{PSA}$ of the power supply assembly based on the phase voltages $u_a$, $u_b$ and $u_c$ using a suitable known method. In an alternative embodiment the output frequency of the power supply assembly is obtained using a phase-locked loop. The grid frequency $\omega_{grid}$ is a long-term average of the output frequency $\omega_{PSA}$ of the power supply assembly stored in the block b2. The long-term average of the output frequency $\omega_{PSA}$ is practically equal to an average frequency of the common electricity network GRD since in normal operating conditions the three-phase electricity network EN is a part of the common electricity network GRD. In an alternative embodiment the grid frequency is a frequency determined for synchronization of the power supply assembly PSA with the three-phase electricity network EN. In another alternative embodiment the grid frequency is a value based on measurements carried out in the common electricity network GRD.

Figure 2 shows more detailed information on block $b_1$ of the block diagram of Figure 1. The stimulus signal $\omega_{ai,stim}$ is formed in block $b_1$ by multiplying a difference between the output frequency $\omega_{PSA}$ of the power supply assembly and the grid frequency $\omega_{grid}$ by a stimulus coefficient $k_{ai}$, according to below equation.

$$\omega_{ai,stim} = k_{ai} \left( \omega_{PSA} - \omega_{grid} \right)$$

The electricity network EN has a normal operating state and a potential islanding state. The electricity network EN is transferred from a normal operating state into a potential islanding state if predetermined first conditions are fulfilled. Fulfillment of the first conditions is checked in block $b_{16}$. The electricity network EN is transferred back from the potential islanding state into the normal operating state if predetermined first conditions are no longer fulfilled.

The predetermined first conditions for transferring the electricity network into the potential islanding state comprise condition

$$\left| \frac{d}{dt} X_\omega^{-1} \right| > 0 \ ,$$

wherein $X_\omega$ is a reactance seen from an output of the power supply assembly PSA. Change in the output frequency of the power supply assembly PSA affects said reactance $X_\omega$. Monitoring a time derivative of a multiplicative inverse of the reactance $X_\omega$ enables using a small value for the stimulus coefficient $k_{ai}$ in a normal operating state of the electricity network EN. The predetermined first conditions for transferring the electricity network into the potential islanding state also comprise condition

$$\left| \frac{d}{dt} \left( \omega_{PSA} - \omega_{grid} \right) \right| > 0 \ ,$$

wherein $\omega_{PSA}$ is the output frequency of the power supply assembly PSA, and $\omega_{grid}$ is the grid frequency.

In the embodiment of Figure 2 the predetermined first conditions are fulfilled if at least one of the above inequalities is true. If at least one of the above inequalities is true, an output of block $b_{16}$ is TRUE and a potential islanding state is present. In a potential islanding state block $b_{18}$ assigns value $k_{ai,dui}$ for the stimulus coefficient $k_{ai}$. If none of the above inequalities is true, an output of block $b_{16}$ is FALSE and the electricity network EN is allowed to remain in a normal operating state. In a normal operating state block $b_{18}$ assigns value $k_{ai,noi}$ for the stimulus coefficient $k_{ai}$.

Each of the above inequalities comprises comparing an absolute value with zero. One skilled in the art understands that in some embodiments it is useful to compare an absolute value with a limit value greater than zero. In such embodiments above inequalities can be modified into below form

$$\left|\frac{d}{dt}X_\omega^{-1}\right| > \alpha_1$$

$$\left|\frac{d}{dt}\left(\omega_{PSA} - \omega_{grid}\right)\right| > \alpha_2,$$

wherein $\alpha_1$ is a first limit value and $\alpha_2$ is a second limit value. The predetermined first conditions for transferring the electricity network into the potential islanding state may comprise one or both of these modified inequalities. Magnitudes of the first limit value $\alpha_1$ and the second limit value $\alpha_2$ may have embodiment-specific values.

The stimulus coefficient $k_{ai,noi}$ is a function of an active output current of the power supply assembly PSA. In other words the stimulus coefficient $k_{ai,noi}$ depends on an active output current of the power supply assembly PSA. The stimulus coefficient $k_{ai,noi}$ is calculated in block $b_{17}$. The active output current of the power supply assembly is the active output current that the power supply assembly PSA supplies into the electricity network EN. If the power supply assembly PSA takes active current from the electricity network EN the active output current has a negative sign.

Herein a stimulus coefficient is considered to be a function of an active output current of the power supply assembly if the stimulus coefficient is a function of an active power of the power supply assembly. After all, a voltage is usually more or less constant and therefore a change in an active power correlates substantially with a change in an active output current of the power supply assembly. Thus a stimulus coefficient is considered not to be a function of an active output current of the power supply assembly only if the stimulus coefficient is independent of the active output current of the power supply assembly.

In block $b_{17}$ the stimulus coefficient $k_{ai,noi}$ is calculated as a function of a grid frequency active current $i_{p,\omega}$ of the power supply assembly PSA as explained below. In embodiments where there is only little disturbance in an electricity network it is possible to use an unfiltered value of an active output current of the power supply assembly.

In an embodiment the stimulus coefficient $k_{ai,noi}$ is obtainable by subtracting an absolute value of the grid frequency active current $i_{p,\omega}$ of the power supply assembly from a first constant $k_{ai,const1}$, according to below equation.

$$k_{ai,noi} = k_{ai,const1} - \left|i_{p,\omega}\right|$$

When a per-unit system is used the first constant $k_{ai,const1}$ may have a value 3, for example. In the per-unit system a grid frequency active current $i_{p,\omega}$ of the power supply assembly PSA has a value 1 pu (per-unit) when the power supply assembly PSA supplies active current into the electricity network EN with a nominal value thereof.

The stimulus coefficient $k_{ai}$ has a higher absolute value during a potential islanding state than during a normal operating state. In an embodiment the stimulus coefficient $k_{ai,dui}$ is obtainable by addition of a second constant $k_{ai,const2}$ and a previous value of the stimulus coefficient $k_{ai,prev}$, according to below equation.

$$k_{ai,dui} = k_{ai,const2} + k_{ai,prev}$$

A previous value $k_{ai,prev}$ of the stimulus coefficient is a value previously calculated for the stimulus coefficient $k_{ai}$. In the block diagram of Figure 2 forming of the previous value, i.e. delaying a signal representing the stimulus coefficient $k_{ai}$, is denoted with 1/z. When a per-unit system is used the second constant $k_{ai,const2}$ may have a value 0.5, for example. In an embodiment a new value for the stimulus coefficient $k_{ai}$ is determined at 2 ms intervals. In an embodiment a maximum value $k_{ai,max}$ is set for the stimulus coefficient such that during a potential islanding state the stimulus coefficient $k_{ai}$ is not allowed to exceed the maximum value $k_{ai,max}$ of the stimulus coefficient.

Block $b_{15}$ supplies block $b_{16}$ with a multiplicative inverse of the reactance $X_\omega$. This multiplicative inverse value is formed in blocks $b_{11}$, $b_{14}$ and $b_{15}$ based on the phase currents $i_a$, $i_b$ and $i_c$, and the phase voltages $u_a$, $u_b$ and $u_c$. In block $b_{11}$ components with grid frequency are separated from the phase currents and phase voltages. Resulting grid frequency phase currents are denoted with $i_{a,\omega}$, $i_{b,\omega}$ and $i_{c,\omega}$, and resulting grid frequency phase voltages are denoted with $u_{a,\omega}$, $u_{b,\omega}$ and $u_{c,\omega}$. In block $b_{14}$ a magnitude of a grid frequency voltage is calculated based on the grid frequency phase voltages $u_{a,\omega}$, $u_{b,\omega}$ and $u_{c,\omega}$. In block $b_{15}$ a multiplicative inverse of the reactance $X_\omega$ is calculated according to equation

$$X_\omega^{-1} = \frac{i_{q,\omega}}{|\underline{u}_\omega|},$$

where $i_{q,\omega}$ is a grid frequency reactive current, and $|\underline{u}_\omega|$ is a magnitude of a grid frequency voltage.

In block $b_{12}$ a grid frequency active power $p_\omega$ and a grid frequency reactive power $q_\omega$ are calculated based on the grid frequency phase currents $i_{a,\omega}$, $i_{b,\omega}$ and $i_{c,\omega}$ and the grid frequency phase voltages $u_{a,\omega}$, $u_{b,\omega}$ and $u_{c,\omega}$. In block $b_{13}$ a grid frequency reactive current $i_{q,\omega}$ and a grid frequency active current $i_{p,\omega}$ are calculated based on the grid frequency active power $p_\omega$ and grid

frequency reactive power $q_\omega$.

In an embodiment grid frequency components such as the grid frequency phase currents $i_{a,\omega}$, $i_{b,\omega}$ and $i_{c,\omega}$ and the grid frequency phase voltages $u_{a,\omega}$, $u_{b,\omega}$ and $u_{c,\omega}$ are components whose frequency corresponds to the grid frequency $\omega_{grid}$ defined above. In an alternative embodiment grid frequency components are components whose frequency corresponds to a frequency of the three-phase electricity network.

The grid frequency components may be formed by band-pass filtering original components. For example, the grid frequency phase currents $i_{a,\omega}$, $i_{b,\omega}$ and $i_{c,\omega}$ and the grid frequency phase voltages $u_{a,\omega}$, $u_{b,\omega}$ and $u_{c,\omega}$ may be formed by band-pass filtering the phase currents $i_a$, $i_b$ and $i_c$ of the electricity network EN and the phase voltages $u_a$, $u_b$ and $u_c$ of the electricity network EN, respectively.

Grid codes and standards relating to electricity networks normally do not allow a three-phase islanding state. Further, grid codes set a time limit in which a three-phase islanding state must be cleared. Such a time limit is different in different countries and may be in a range from 0.3 to 1.0 seconds. Therefore a method according to an embodiment of the invention comprises stopping supplying power into the electricity network by the power supply assembly as a response to the detection of a three-phase islanding state. Alternatively it is possible to change an operating state of the electricity network as a response to a detected three-phase islanding state. In some embodiments an alarm is provided to operating personnel of the electricity network so that the operating personnel can stop the power supply assembly from supplying power into the electricity network or to change an operating state of the electricity network in order to take the three-phase islanding state into account.

Power supply into the electricity network by the power supply assembly may be stopped by opening a switch between the power supply assembly and the electricity network. Such a switch is not depicted in Figures. In an alternative embodiment stopping supplying power into the electricity network by the power supply assembly comprises shutting down the power supply assembly.

It will be obvious to a person skilled in the art that the inventive concept can be implemented in various ways. The invention and its embodiments are not limited to the examples described above but may vary within the scope of the claims.

**Claims**

1. A method for detecting a three-phase islanding state in a three-phase electricity network, the method comprising:

   supplying power into a three-phase electricity network (EN) by a power supply assembly (PSA) having an output frequency ($\omega_{PSA}$);

   controlling the output frequency ($\omega_{PSA}$) of the power supply assembly (PSA) with a frequency reference signal ($\omega_{ctrl}$) adapted to deviate the output frequency ($\omega_{PSA}$) of the power supply assembly (PSA) from a grid frequency ($\omega_{grid}$) representing a frequency of a common electricity network (GRD) whose part the three-phase electricity network (EN) is in normal operating conditions;

   monitoring a magnitude of a frequency quantity obtainable from the output frequency ($\omega_{PSA}$) of the power supply assembly; and

   detecting a three-phase islanding state in the electricity network (EN) if the magnitude of the frequency quantity exits an allowable value range, **characterized in that** the method comprises

   forming a stimulus signal ($\omega_{ai,stim}$) obtainable by multiplying a difference between the output frequency ($\omega_{PSA}$) of the power supply assembly and the grid frequency ($\omega_{grid}$) by a stimulus coefficient ($k_{ai}$), wherein forming of the frequency reference signal ($\omega_{ctrl}$) comprises addition of the output frequency ($\omega_{PSA}$) of the power supply assembly and the stimulus signal ($\omega_{ai,stim}$), and during a normal operating state of the electricity network (EN) the stimulus coefficient ($k_{ai}$) is a function of an active output current ($i_{p,\omega}$) of the power supply assembly (PSA).

2. A method according to claim 1, **characterized in that** the method comprises transferring the electricity network (EN) from the normal operating state into a potential islanding state if predetermined first conditions are fulfilled, and the stimulus coefficient ($k_{ai}$) has a higher absolute value during the potential islanding state than during the normal operating state.

3. A method according to claim 1 or 2, **characterized in that** during the normal operating state the stimulus coefficient ($k_{ai}$) is obtainable by subtracting an absolute value of the active output current ($i_{p,\omega}$) of the power supply assembly from a first constant ($k_{ai,const1}$).

4. A method according to claim 2, **characterized in that** the predetermined first conditions for transferring the electricity network into the potential islanding state comprise condition

$$\left|\frac{d}{dt} X_\omega^{-1}\right| > \alpha_1,$$

wherein $X_\omega$ is a reactance seen from an output of the power supply assembly (PSA), and $\alpha_1$ is a first limit value.

**5.** A method according to claim 2 or 4, **characterized in that** the predetermined first conditions for transferring the electricity network into the potential islanding state comprise condition

$$\left|\frac{d}{dt}\left(\omega_{PSA} - \omega_{grid}\right)\right| > \alpha_2,$$

wherein $\omega_{PSA}$ is the output frequency of the power supply assembly (PSA), $\omega_{grid}$ is the grid frequency, and $\alpha_2$ is a second limit value.

**6.** A method according to any one of claim 2, 4 or 5, **characterized in that** during the potential islanding state forming of the stimulus coefficient ($k_{ai}$) comprises addition of a second constant ($k_{ai,const2}$) and a previous value of the stimulus coefficient ($k_{ai,prev}$).

**7.** A method according to claim 6, **characterized in that** the stimulus coefficient ($k_{ai}$) has a maximum value such that during the potential islanding state the stimulus coefficient ($k_{ai}$) is not allowed to exceed the maximum value ($k_{ai,max}$) of the stimulus coefficient.

**8.** A method according to any one of claims 2, 4, 5, 6, or 7, **char-acterized** in that the method comprises transferring the electricity network (EN) from the potential islanding state into the normal operating state if predetermined first conditions are no longer fulfilled.

**9.** A method according to any one of claims 1 to 8, **char-acterized in that** the method comprises stopping supplying power into the electricity network (EN) by the power supply assembly (PSA) as a response to a detection of the three-phase islanding state.

**10.** A system for detecting a three-phase islanding state in a three-phase electricity network, the system comprising:

a power supply assembly (PSA) for supplying power with an output frequency ($\omega_{PSA}$) into a three-phase electricity network (EN); and
control means adapted to
form a frequency reference signal ($\omega_{ctrl}$),
control the output frequency ($\omega_{PSA}$) of the power supply assembly (PSA) with the frequency reference signal ($\omega_{ctrl}$), the frequency reference signal ($\omega_{ctrl}$) being adapted to deviate the output frequency ($\omega_{PSA}$) of the power supply assembly (PSA) from a grid frequency ($\omega_{grid}$) representing a frequency of a common electricity network (GRD) whose part the three-phase electricity network (EN) is in normal operating conditions, monitor a magnitude of a frequency quantity obtainable from the output frequency ($\omega_{PSA}$) of the power supply assembly, and
detect a three-phase islanding state in the electricity network (EN) if the magnitude of the frequency quantity exits an allowable value range, **characterized in that**
the control means is adapted to form a stimulus signal ($\omega_{ai,stim}$) obtainable by multiplying a difference between the output frequency ($\omega_{PSA}$) of the power supply assembly and the grid frequency ($\omega_{grid}$) by a stimulus coefficient ($k_{ai}$), wherein forming of the frequency reference signal ($\omega_{ctrl}$) comprises addition of the output frequency ($\omega_{PSA}$) of the power supply assembly and the stimulus signal ($\omega_{ai,stim}$), and during a normal operating state of the electricity network (EN) the stimulus coefficient ($k_{ai}$) is a function of an active output current ($i_{p,\omega}$) of the power supply assembly (PSA).

**Patentansprüche**

**1.** Verfahren zum Erkennen eines dreiphasigen Inselzustandes in einem dreiphasigen Stromnetz, das Verfahren umfassend:

Liefern von Strom in ein dreiphasiges Stromnetz (EN) mittels einer Stromversorgungsanordnung (PSA) mit einer Ausgangsfrequenz ($\omega_{PSA}$);
Steuern der Ausgangsfrequenz ($\omega_{PSA}$) der Stromversorgungsanordnung (PSA) mit einem Frequenzbezugssignal ($\omega_{ctrl}$), ausgebildet zum Ablenken der Ausgangsfrequenz ($\omega_{PSA}$) der Stromversorgungsanordnung (PSA) von einer Netzfrequenz ($\omega_{grid}$), die eine Frequenz eines gemeinsamen Stromnetzes (GRD) repräsentiert, von dem das dreiphasiges Stromnetz (EN) unter normalen Betriebsbedingungen ein Teil ist;
Überwachen einer Größenordnung einer Frequenzgröße erhältlich von der Ausgangsfrequenz ($\omega_{PSA}$) der Stromversorgungsanordnung; und
Erkennen eines dreiphasigen Inselzustandes in dem dreiphasigen Stromnetz (EN), wenn die Größenordnung der Frequenzgröße einen erlaubten Wertebereich verlässt, **dadurch gekennzeichnet, dass** das Verfahren umfasst
Bilden eines Reizsignals ($\omega_{ai,stim}$), erhältlich durch Multiplizieren einer Differenz zwischen der Ausgangsfrequenz ($\omega_{PSA}$) der Stromversorgungsanordnung und der Netzfrequenz ($\omega_{grid}$) mit einem Reizkoeffizienten ($k_{ai}$), wobei Bilden des Frequenzbezugssignals ($\omega_{ctrl}$) das Hinzufügen der Ausgangsfrequenz ($\omega_{PSA}$) der Stromversorgungsanordnung und des Reizsignals ($\omega_{ai,stim}$) umfasst, und während des normalen Betriebszustands des Stromnetzes (EN), der Reizkoeffizient ($k_{ai}$) eine Funktion eines aktiven Ausgangsstromes ($i_{p,\omega}$) der Stromversorgungsanordnung (PSA) ist.

2. Verfahren nach Anspruch 1, **dadurch gekennzeichnet, dass** das Verfahren umfasst Überführen des Stromnetzes (EN) von dem normalen Betriebszustand in einen potentiellen Inselzustand, wenn vorgegebene erste Bedingungen erfüllt werden, und wobei der Reizkoeffizient ($k_{ai}$) einen höheren absoluten Wert während des potentiellen Inselzustandes aufweist als während des normalen Betriebszustandes.

3. Verfahren nach Anspruch 1 oder 2, **dadurch gekennzeichnet, dass** während des normalen Betriebszustandes der Reizkoeffizient ($k_{ai}$) erhältlich ist durch Subtrahieren eines absoluten Wertes des aktiven Ausgangsstromes ($i_{p,\omega}$) der Stromversorgungsanordnung von einer ersten Konstante ($k_{ai,const1}$).

4. Verfahren nach Anspruch 2, **dadurch gekennzeichnet, dass** die vorgegebenen ersten Bedingungen zum Überführen des Stromnetzes in den potentiellen Inselzustand die Bedingung umfassen

$$\left|\frac{d}{dt}X_\omega^{-1}\right| > \alpha_1,$$

wobei $X_\omega$ eine Reaktanz ist, gesehen von einem Ausgang der Stromversorgungsanordnung (PSA), und $\alpha_1$ ein erster Grenzwert ist.

5. Verfahren nach Anspruch 2 oder 4, **dadurch gekennzeichnet, dass** die vorgegebenen ersten Bedingungen zum Überführen des Stromnetzes in den potentiellen Inselzustand die Bedingung umfassen

$$\left|\frac{d}{dt}\left(\omega_{PSA} - \omega_{grid}\right)\right| > \alpha_2,$$

wobei $\omega_{PSA}$ eine Ausgangsfrequenz der Stromversorgungsanordnung (PSA) ist, $\omega_{grid}$ die Netzfrequenz ist und $\alpha_2$ ein zweiter Grenzwert ist.

6. Verfahren nach einem der Ansprüche 2, 4, oder 5, **dadurch gekennzeichnet, dass** während des potentiellen Inselzustandes Bilden des Reizkoeffizienten ($k_{ai}$) das Hinzufügen einer zweiten Konstante ($k_{ai,const2}$) und eines vorherigen Wertes des Reizkoeffizienten ($k_{ai,prev}$) umfasst.

7. Verfahren nach Anspruch 6, **dadurch gekennzeichnet, dass** der Reizkoeffizient ($k_{ai}$) einen maxi-

malen Wert aufweist, sodass während des potentiellen Inselzustandes dem Reizkoeffizienten ($k_{ai}$) nicht erlaubt ist, den maximalen Wert ($k_{ai,max}$) des Reizkoeffizienten zu überschreiten.

8. Verfahren nach einem der Ansprüche 2, 4, 5, 6 oder 7 **dadurch gekennzeichnet, dass** das Verfahren umfasst Überführen des Stromnetzes (EN) von dem potentiellen Inselzustand in den normalen Betriebszustand, wenn die vorgegebenen ersten Bedingungen nicht länger erfüllt werden.

9. Verfahren nach einem der Ansprüche 1 bis 8, **dadurch gekennzeichnet, dass** das Verfahren umfasst Beenden des Lieferns von Strom in das Stromnetz (EN) mittels der Stromversorgungsanordnung (PSA) als eine Reaktion auf ein Erkennen des dreiphasigen Inselzustandes.

10. System zum Erkennen eines dreiphasigen Inselzustandes in einem dreiphasigen Stromnetz, das System umfassend:

eine Stromversorgungsanordnung (PSA) zum Liefern von Strom mit einer Ausgangsfrequenz ($\omega_{PSA}$) in ein dreiphasiges Stromnetz (EN); und Steuermittel ausgebildet zum Bilden eines Frequenzbezugssignals ($\omega_{ctrl}$), Steuern der Ausgangsfrequenz ($\omega_{PSA}$) der Stromversorgungsanordnung (PSA) mit dem Frequenzbezugssignal ($\omega_{ctrl}$), wobei das Frequenzbezugssignal ($\omega_{ctrl}$) ausgebildet ist zum Ablenken der Ausgangsfrequenz ($\omega_{PSA}$) der Stromversorgungsanordnung (PSA) von einer Netzfrequenz ($\omega_{grid}$), die eine Frequenz eines gemeinsamen Stromnetzes (GRD) repräsentiert, von dem das dreiphasiges Stromnetz (EN) unter normalen Betriebsbedingungen ein Teil ist, Überwachen einer Größenordnung einer Frequenzgröße erhältlich von der Ausgangsfrequenz ($\omega_{PSA}$) der Stromversorgungsanordnung, und Erkennen eines dreiphasigen Inselzustandes in dem dreiphasigen Stromnetz (EN), wenn die Größenordnung der Frequenzgröße einen erlaubten Wertebereich verlässt, **dadurch gekennzeichnet, dass** die Steuermittel ausgebildet sind zum Bilden eines Reizsignals ($\omega_{ai,stim}$), erhältlich durch Multiplizieren einer Differenz zwischen der Ausgangsfrequenz ($\omega_{PSA}$) der Stromversorgungsanordnung und der Netzfrequenz ($\omega_{grid}$) mit einem Reizkoeffizienten ($k_{ai}$), wobei Bilden des Frequenzbezugssignals ($\omega_{ctrl}$) das Hinzufügen der Ausgangsfrequenz ($\omega_{PSA}$) der Stromversorgungsanordnung und des Reizsignals ($\omega_{ai,stim}$) umfasst, und während des normalen Betriebszustands des Stromnetzes (EN), der Reizkoeffizient ($k_{ai}$) eine Funktion eines aktiven Ausgangsstromes ($i_{p,\omega}$) der Stromversorgungsanordnung (PSA) ist.

## Revendications

1. Procédé pour détecter un état d'îlotage triphasé dans un réseau électrique triphasé, le procédé comprenant :

   la fourniture d'énergie dans un réseau électrique triphasé (EN) par un ensemble d'alimentation en énergie (PSA) ayant une fréquence de sortie ($\omega_{PSA}$) ;
   la commande de la fréquence de sortie ($\omega_{PSA}$) de l'ensemble d'alimentation en énergie (PSA) avec un signal de référence de fréquence ($\omega_{ctrl}$) conçu pour dévier la fréquence de sortie ($\omega_{PSA}$) de l'ensemble d'alimentation en énergie (PSA) d'une fréquence de réseau ($\omega_{grid}$) représentant une fréquence d'un réseau électrique commun (GRD) dont la partie réseau électrique triphasé (EN) est dans des conditions de fonctionnement normales ;
   le contrôle d'une amplitude d'une quantité de fréquence qu'on peut obtenir de la fréquence de sortie ($\omega_{PSA}$) de l'ensemble d'alimentation en énergie ; et
   la détection d'un état d'îlotage triphasé dans le réseau électrique (EN) si l'amplitude de la quantité de fréquence quitte une plage de valeurs admissibles, **caractérisé en ce que** le procédé comprend
   la formation d'un signal de stimulus ($\omega_{ai,stim}$) qu'on peut obtenir en multipliant une différence entre la fréquence de sortie ($\omega_{PSA}$) de l'ensemble d'alimentation en énergie et la fréquence de réseau ($\omega_{grid}$) par un coefficient de stimulus ($k_{ai}$), dans laquelle la formation du signal de référence de fréquence ($\omega_{ctrl}$) comprend l'addition de la fréquence de sortie ($\omega_{PSA}$) de l'ensemble d'alimentation en énergie et du signal de stimulus ($\omega_{ai,stim}$), et pendant un état de fonctionnement normal du réseau électrique (EN) le coefficient de stimulus ($k_{ai}$) est une fonction d'un courant de sortie actif ($i_{p,\omega}$) de l'ensemble d'alimentation en énergie (PSA).

2. Procédé selon la revendication 1, **caractérisé en ce que** le procédé comprend le transfert du réseau électrique (EN) de l'état de fonctionnement normal vers un état d'îlotage potentiel si des premières conditions prédéterminées sont satisfaites, et le coefficient de stimulus ($k_{ai}$) a une valeur absolue plus élevée pendant l'état d'îlotage potentiel que pendant l'état de fonctionnement normal.

3. Procédé selon la revendication 1 ou 2, **caractérisé en ce que** pendant l'état de fonctionnement normal le coefficient de stimulus ($k_{ai}$) peut être obtenu en soustrayant une valeur absolue du courant de sortie actif ($i_{p,\omega}$) de l'ensemble d'alimentation en énergie d'une première constante ($k_{ai,const1}$).

4. Procédé selon la revendication 2, **caractérisé en ce que** les premières conditions prédéterminées pour transférer le réseau électrique vers l'état d'îlotage potentiel comprennent la condition

$$\left|\frac{d}{dt} X_\omega^{-1}\right| > \alpha_1 ,$$

dans laquelle $X_\omega$ est une réactance vue à partir d'une sortie de l'ensemble d'alimentation en énergie (PSA) et $\alpha_1$ est une première valeur de limite.

5. Procédé selon la revendication 2 ou 4, **caractérisé en ce que** les premières conditions prédéterminées pour transférer le réseau électrique vers l'état d'îlotage potentiel comprennent la condition

$$\left|\frac{d}{dt} \left(\omega_{PSA} - \omega_{grid}\right)\right| > \alpha_2 ,$$

dans laquelle $\omega_{PSA}$ est la fréquence de sortie de l'ensemble d'alimentation en énergie (PSA), $\omega_{grid}$ est la fréquence de réseau et $\alpha_2$ est une seconde valeur de limite.

6. Procédé selon l'une quelconque des revendications 2, 4 ou 5, **caractérisé en ce que** pendant l'état d'îlotage potentiel la formation du coefficient de stimulus ($k_{ai}$) comprend l'addition d'une seconde constante ($k_{ai,const2}$) et d'une valeur précédente du coefficient de stimulus ($k_{ai,prev}$).

7. Procédé selon la revendication 6, **caractérisé en ce que** le coefficient de stimulus ($k_{ai}$) a une valeur maximale de sorte que pendant l'état d'îlotage potentiel le coefficient de stimulus ($k_{ai}$) n'est pas autorisé à dépasser la valeur maximale ($k_{ai,max}$) du coefficient de stimulus.

8. Procédé selon l'une quelconque des revendications 2, 4, 5, 6, ou 7, **caractérisé en ce que** le procédé comprend le transfert du réseau électrique (EN) de l'état d'îlotage potentiel vers l'état de fonctionnement normal si des premières conditions prédéterminées ne sont plus satisfaites.

9. Procédé selon l'une quelconque des revendications 1 à 8, **caractérisé en ce que** le procédé comprend l'arrêt de la fourniture d'énergie dans le réseau électrique (EN) par l'ensemble d'alimentation en énergie (PSA) comme réponse à une détection de l'état d'îlotage triphasé.

10. Système pour détecter un état d'îlotage triphasé dans un réseau électrique triphasé, le système comprenant :

un ensemble d'alimentation en énergie (PSA) pour fournir de l'énergie avec une fréquence de sortie ($\omega_{PSA}$) dans un réseau électrique triphasé (EN) ; et
un moyen de commande conçu pour
former un signal de référence de fréquence ($\omega_{ctrl}$),
commander la fréquence de sortie ($\omega_{PSA}$) de l'ensemble d'alimentation en énergie (PSA) avec le signal de référence de fréquence ($\omega_{ctrl}$), le signal de référence de fréquence ($\omega_{ctrl}$) étant conçu pour dévier la fréquence de sortie ($\omega_{PSA}$) de l'ensemble d'alimentation en énergie (PSA) d'une fréquence de réseau ($\omega_{grid}$) représentant une fréquence d'un réseau électrique commun (GRD) dont la partie réseau électrique triphasé (EN) est dans des conditions de fonctionnement normales,
contrôler une amplitude d'une quantité de fréquence qu'on peut obtenir de la fréquence de sortie ($\omega_{PSA}$) de l'ensemble d'alimentation en énergie, et
détecter un état d'îlotage triphasé dans le réseau électrique (EN) si l'amplitude de la quantité de fréquence quitte une plage de valeurs admissibles, **caractérisé en ce que**
le moyen de commande est conçu pour former un signal de stimulus ($\omega_{ai,stim}$) qu'on peut obtenir en multipliant une différence entre la fréquence de sortie ($\omega_{PSA}$) de l'ensemble d'alimentation en énergie et la fréquence de réseau ($\omega_{grid}$) par un coefficient de stimulus ($k_{ai}$), dans lequel la formation du signal de référence de fréquence ($\omega_{ctrl}$) comprend l'addition de la fréquence de sortie ($\omega_{PSA}$) de l'ensemble d'alimentation en énergie et du signal de stimulus ($\omega_{ai,stim}$), et pendant un état de fonctionnement normal du réseau électrique (EN) le coefficient de stimulus ($k_{ai}$) est une fonction d'un courant de sortie actif ($ip,\omega$) de l'ensemble d'alimentation en énergie (PSA).

Fig. 1

Fig. 2

**EP 2 937 965 B1**

REFERENCES CITED IN THE DESCRIPTION

**Patent documents cited in the description**

- EP 0810713 A2
- WO 2011097147 A2